# FASCICULE DE BREVET EUROPEEN

(11) **EP 0 459 863 B1**
(45) Date de publication et mention de la délivrance du brevet: **21.07.1993**
(21) Numéro de dépôt: 91401301.6
(22) Date de dépôt: 21.05.1991
(51) Int. Cl.: G06F 11/26

(54) **Circuit intégré avec broche de détection de mode**
Integrierter Schaltkreis mit Anschlussstift zur Modusfeststellung
Integrated circuit with mode detection pin

(30) Priorité: 30.05.1990 FR 9006717
(43) Date de publication de la demande: 04.12.1991
(73) Titulaire: SGS-THOMSON MICROELECTRONICS S.A., 94250 Gentilly (FR)
(72) Inventeur: Nicolai, Jean, F-75116 Paris (FR)
(74) Mandataire: Schmit, Christian Norbert Marie

(56) Documents cités:
- EP-A- 0 141 681
- JP-A- 5 615 384
- US-A- 4 837 505

## Description

L'invention concerne les circuits intégrés.

Dans de nombreux cas, et tout particulièrement pour des circuits intégrés complexes, on souhaite disposer d'une ou plusieurs broches permettant de définir à partir de l'extérieur un mode de fonctionnement déterminé du circuit, parmi plusieurs modes possibles. C'est le cas pour les microprocesseurs, les mémoires, et beaucoup d'autres circuits correspondant à des applications variées.

Par exemple, on veut pouvoir mettre le circuit soit en mode de test soit en mode de fonctionnement normal. Ou encore, on veut que l'utilisateur ait plusieurs options de fonctionnement possibles, dont il choisira une par l'intermédiaire d'une broche réservée à cet effet.

La solution classique pour cela consiste à appliquer de l'extérieur un niveau logique 0 ou 1 sur la broche, en fonction du mode choisi. Un détecteur interne au circuit intégré examine l'état de la broche et fournit au reste du circuit une commande appropriée qui fait fonctionner le circuit soit dans un mode soit dans un autre en fonction du niveau logique détecté.

Si le nombre de modes de fonctionnement possibles est supérieur à 2, il faut plus d'une broche pour définir le mode désiré.

C'est la solution la plus simple. Une solution plus économique en nombre de broches a été imaginée. Elle consiste à prévoir un détecteur apte à reconnaître trois états possibles de la broche : état logique 0 ou état logique 1, ou état haute impédance (broche non connectée ou connectée à une impédance très élevée. Des documents US-A-4 837 505 et EP-A-141 681, il est connu des circuits qui distinguent 1 parmi 3 niveaux de tension possibles sur une même broche. Ainsi, chaque broche permet de définir de l'extérieur trois modes de fonctionnement possibles.

Pour un nombre de modes désiré, on réduit ainsi le nombre total de broches du circuit intégré. Cela est très important étant donné que le prix du circuit intégré est fortement affecté par le prix du boîtier et le prix du boîtier dépend fortement du nombre de broches. On peut citer par exemple le cas d'un circuit de 20 broches dans lequel une broche supplémentaire obligerait en fait à passer à un boîtier de 24 broches car il n'y a pas de boîtier standard disponible entre 20 et 24 broches.

Les détecteurs existants pour détecter soit un niveau logique 0, soit un niveau logique 1, soit encore un état haute impédance, présentent cependant l'inconvénient de consommer un courant important non seulement pendant la détection, mais aussi en régime permanent. On pourra se reporter à la demande japonaise 56-153 840.

Un but de l'invention est de proposer un circuit simple, peu coûteux, et consommant peu de courant (surtout en régime permanent), pour détecter un état parmi trois sur une broche d'un circuit intégré.

Le circuit intégré selon l'invention comporte : une broche d'entrée sur laquelle on veut détecter un état parmi trois états correspondant à deux niveaux logiques et un état haute impédance, une résistance reliée à la broche, un ensemble d'interrupteurs connectés entre la broche, la résistance et deux noeuds de circuit à des potentiels représentant respectivement un premier et un deuxième niveau logique, un registre de mémorisation d'au moins deux états logiques, et un moyen de commande pour commander les interrupteurs pour
- dans une première phase de lecture relier la broche à l'un des noeuds par l'intermédiaire de la résistance, et simultanément relier la broche au registre d'états logiques pour mémoriser dans ce registre un premier niveau logique correspondant à celui auquel est portée la broche dans ladite première phase;
- dans une deuxième phase de lecture relier la broche à l'autre noeud par l'intermédiaire de la résistance, et simultanément relier la broche au registre d'états logiques pour mémoriser dans ce registre un deuxième état logique correspondant à celui auquel est portée la broche dans ladite deuxième phase;

Le circuit comportant en outre un décodeur pour fournir un signal à partir du registre de mémorisation d'états logiques, ledit signal définissant l'état de la broche à partir d'une combinaison des niveaux logiques pris par la broche au cours des deux phases.

Le registre mémorise de préférence les deux niveaux logiques pris par la broche au cours des deux phases. Le registre a alors deux sorties qui sont transmises à un décodeur qui fournit le signal de sortie désiré servant à imposer un mode de fonctionnement du circuit intégré en fonction de l'état de la broche.

On prévoit de préférence selon l'invention qu'un étage tampon est intercalé entre la broche et le le registre, et qu'un interrupteur est prévu pour déconnecter la broche de l'entrée de l'étage tampon en dehors des deux phases de lecture et pour maintenir cette entrée à un niveau logique haut ou bas en dehors des deux phases de lecture.

De préférence, les interrupteurs comprennent :
- un premier et un deuxième interrupteurs en série entre deux bornes d'alimentation du circuit intégré, la résistance étant connectée entre la broche et le point milieu des deux interrupteurs,
un troisième interrupteur pour relier la broche au registre, et un quatrième interrupteur pour relier le registre à une borne d'alimentation.

Le circuit intégré est de préférence réalisé en technologie CMOS pour limiter la consommation de courant au maximum.

D'autres caractéristiques et avantages de l'invention apparaîtront à la lecture de la description détaillée qui suit et qui est faite en référence aux dessins annexés dans lesquels :
- la figure 1 représente le détecteur d'état selon l'invention;
- la figure 2 (2a, 2b, 2c) représente les configurations du détecteur pendant les différentes phases.

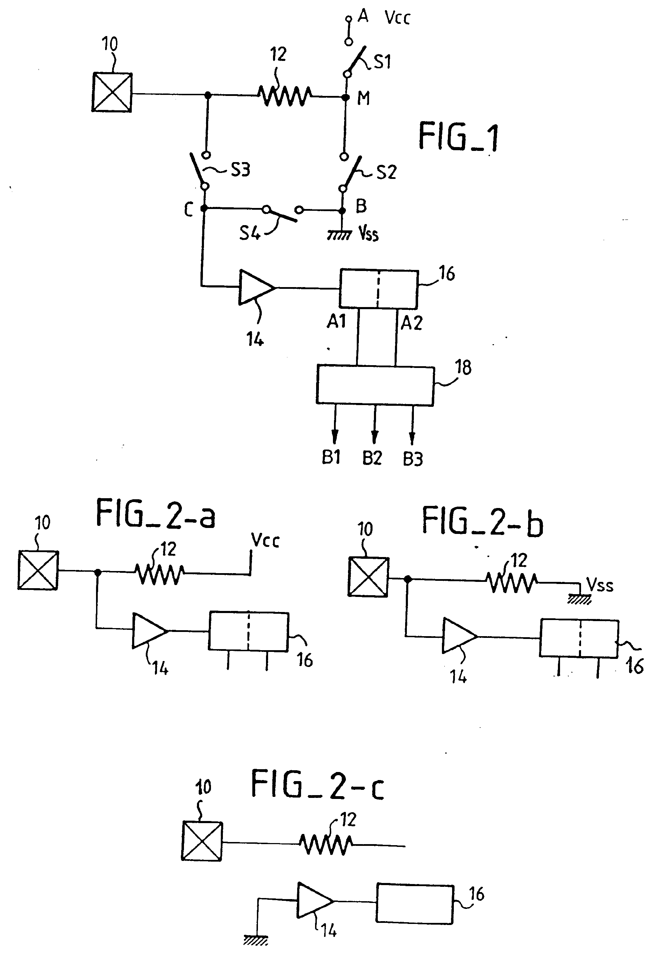

A la figure 1 est représenté le mode de réalisation préférentiel de l'invention.

La broche servant à définir de l'extérieur un mode de fonctionnement du circuit intégré est désignée par la référence 10. Elle est susceptible d'être placée de l'extérieur dans trois états possibles : état logique bas correspondant à un niveau logique de tension qui est par exemple celui d'une première borne d'alimentation du circuit intégré (Vss), état logique haut correspondant à un niveau logique qui est celui d'une deuxième tension d'alimentation (Vcc), ou encore état haute impédance où la borne est en l'air ou raccordée à l'extérieur du circuit à une impédance très élevée.

La broche 10 est raccordée, à l'intérieur du circuit intégré, à un détecteur d'état qui comprend essentiellement une résistance, des interrupteurs, et un moyen pour détecter le niveau logique sur la broche dans deux configurations différentes des interrupteurs.

Plus précisément, le détecteur d'état comprend une résistance 12 raccordée d'un côté à la broche 10, et de l'autre au point milieu M d'un ensemble en série de deux interrupteurs S1 et S2.

L'interrupteur S1 est connecté par ailleurs à un noeud A dont le potentiel correspond au niveau logique haut. De préférence, le noeud A est tout simplement au potentiel d'alimentation haut Vcc. Au contraire, l'interrupteur S2 est connecté à un noeud B dont le potentiel correspond au niveau logique bas; de préférence le noeud B est au potentiel d'alimentation bas Vss.

La broche 10 est par ailleurs raccordée , par l'intermédiaire d'un troisième interrupteur S3, à un noeud C qui constitue une entrée d'un amplificateur tampon 14 dont la sortie est raccordée à un registre 16 permettant d'enregistrer le niveau logique présent sur le noeud C.

Un quatrième interrupteur permet de mettre le noeud C à l'un des potentiels d'alimentation, ici le potentiel bas Vss.

Enfin, le détecteur comporte un moyen de commande non représenté pour contrôler la fermeture et l'ouverture des interrupteurs selon un cycle qui sera détaillé plus loin, et un petit circuit logique 18 pour fournir, à partir du contenu du registre 16, un signal représentatif de l'état de la broche, donc un signal représentatif du mode de fonctionnement qu'on veut imposer de l'extérieur.

Le séquenceur délivre les signaux de commande suivants :
- en dehors des phases de lecture, c'est-à-dire en dehors des instants où l'on veut déterminer l'état de la broche, l'interrupteur S4 est fermé, les interrupteurs S1, S2, S3 sont ouverts; ainsi, il n'y a pas de consommation de courant possible par la broche 10; par ailleurs, en maintenant l'entrée de l'amplificateur tampon à Vss par S4, on minimise, pour des circuits de technologie CMOS quine consomment pas de courant au repos, la consommation de l'amplificateur 14; il y aurait un risque en effet que l'amplificateur consomme un courant non négligeable si le potentiel de son entrée était flottant;
- pendant les phases de lecture de l'état de la broche, l'interrupteur S4 est ouvert et l'interrupteur S3 est fermé. Ces phases de lecture se décomposent en une première phase pendant laquelle l'interrupteur S1 est fermé et S2 est ouvert, et une deuxième phase pendant laquelle S2 est fermé et S1 ouvert (les phases peuvent être inversées).

Pendant la première phase, on obtient une configuration représentée à la figure 2a, dans laquelle la broche est reliée d'une part à l'entrée de l'amplificateur 14 et d'autre part à Vcc par l'intermédiaire de la résistance 12. Si la broche est maintenue de l'extérieur au niveau logique bas Vss, c'est ce niveau qui est transmis par l'intermédiaire de l'amplificateur au registre 16; le registre prend ce niveau en mémoire; si la broche est à Vcc, c'est le niveau logique haut qui est transmis et mémorisé dans le registre; si enfin la broche est à l'extérieur en haute impédance, elle se trouve raccordée à Vcc par la résistance dont la valeur R est très inférieure à la haute impédance extérieure; c'est donc encore le niveau logique haut Vcc qui est transmis et mémorisé dans le registre 16.

Pendant la deuxième phase, on obtient la configuration de circuit de la figure 2b; dans ce cas, si la broche est maintenue extérieurement à Vss ou Vcc, c'est encore le niveau bas ou haut respectivement qui est transmis au registre; mais si la broche est en haute impédance, elle prend le niveau logique bas du fait qu'elle est raccordée à Vss par la résistance 12.

A la fin de la deuxième phase, si on combine les informations recueillies dans les deux phases, on peut définir l'état de la broche : si on a dans le registre deux fois un état bas, c'est que la broche était à l'état bas; si on a deux fois un état haut, c'est que la broche était à l'état haut; mais si on a une fois un état haut et une fois un état bas, c'est que la broche était en haute impédance pendant la lecture.

Les sorties A1 et A2 du registre, représentant les états logiques de la broche au cours des deux phases de la lecture, sont donc combinées dans un petit circuit logique 18 qui est un décodeur fournissant par exemple trois sorties B1, B2, B3 représentant chacune un état respectif de la broche 10. Ces sorties B1, B2, B3 sont utilisées pour modifier des fonctionnalités internes du circuit intégré pour le faire passer dans un mode de fonctionnement particulier.

Dans le cas où il y a plusieurs broches servant à définir un mode, chaque broche est raccordée à un détecteur tel que celui de la figure 1, mais le circuit logique 18 peut être un circuit commun décodant la combinaison d'états relevés dans les registres tels que 16.

A titre d'exemple, la résistance 12 peut avoir une valeur de l'ordre de 10 kilohms, mais sa valeur n'est pas critique, pourvu qu'elle soit suffisamment faible pour bien tirer la broche au potentiel Vss ou Vcc lorsque la broche est en haute impédance, et pas trop faible pour ne pas contrarier le maintien de la broche par l'extérieur à un potentiel déterminé lorsque la broche n'est pas en haute impédance.

En dehors de la lecture il n'y a pas de consommation de courant (en technologie CMOS); la configuration du circuit est celle de la figure 2c. Pendant la lecture il y a une petite consommation de courant due au potentiel Vcc-Vss qui peut traverser la résistance lorsque la broche est au potentiel Vss ou Vcc.

## Revendications

1. Circuit intégré comportant une broche d'entrée (10) sur laquelle on veut détecter un état parmi trois états correspondant à deux niveaux logiques et un état haute impédance, une résistance (12) reliée à la broche, un ensemble d'interrupteurs (S1-S4) connectés entre la broche, la résistance et deux noeuds de circuit (A et B) à des potentiels représentant respectivement un premier et un deuxième niveau logique, un registre (16) de mémorisation d'au moins deux états logiques, et un moyen de commande pour commander les interrupteurs pour
- dans une première phase de lecture relier la broche à l'un des noeuds (A) par l'intermédiaire de la résistance, et simultanément relier la broche au registre (16) d'états logiques pour mémoriser dans ce registre un premier niveau logique correspondant à celui auquel est portée la broche dans ladite première phase;
- dans une deuxième phase de lecture relier la broche à l'autre noeud (B) par l'intermédiaire de la résistance, et simultanément relier la broche au registre (16) d'états logiques pour mémoriser dans ce registre un deuxième état logique correspondant à celui auquel est portée la broche dans ladite deuxième phase;
le circuit comportant en outre un décodeur (18) pour fournir un signal à partir du registre (16) de mémorisation d'états logiques, ledit signal définissant l'état de la broche à partir d'une combinaison des niveaux logiques pris par la broche au cours des deux phases.

2. Circuit selon la revendication 1, caractérisé en ce que le registre mémorise les deux niveaux logiques pris par la broche au cours des deux phases de lecture respectivement, le registre ayant deux sorties correspondantes appliquées aux entrées du décodeur.

3. Circuit selon l'une des revendications 1 et 2, caractérisé en ce qu'un étage tampon (14) est intercalé entre la broche et le registre, et qu'un interrupteur (S4) est prévu pour déconnecter la broche de l'entrée de l'étage tampon en dehors des deux phases de lecture et pour maintenir alors cette entrée à un niveau logique haut ou bas.

4. Circuit selon l'une des revendications 1 à 3, caractérisé en ce que les interrupteurs comprennent :
- un premier et un deuxième interrupteurs (S1 et S2) en série entre deux bornes d'alimentation du circuit intégré, la résistance étant connectée entre la broche et le point milieu des deux interrupteurs,
- un troisième interrupteur (S3) pour relier la broche au registre, et un quatrième interrupteur (S4) pour relier le registre à une borne d'alimentation.

## Patentansprüche

1. Integrierte Schaltung, mit einem Eingangsanschluß (10), an dem einer von drei Zuständen erfaßt werden soll, die zwei logischen Pegeln und einem Zustand mit hoher Impedanz entsprechen, einem mit dem Anschluß verbundenen Widerstand (12), einer Schaltergruppe (S1 - S4) die zwischen den Anschluß, den Widerstand und zwei Schaltungsknoten (A und B) geschaltet sind, wobei die Schaltungsknoten Potentiale besitzen, die einen ersten bzw. einen zweiten logischen Pegel darstellen, einem Register (16) zur Speicherung wenigstens zweier logischer Zustände und einem Steuermittel zum Steuern der Schalter, um
- in einer ersten Phase des Lesens den Anschluß über den Widerstand mit einem der Knoten (A) zu verbinden und gleichzeitig den Anschluß mit dem Register (16) für logische Zustände zu verbinden, um in diesem Register einen ersten logischen Pegel zu speichern, der demjenigen entspricht, auf dem der Anschluß in der ersten Phase gehalten wird;
- in einer zweiten Phase des Lesens den Anschluß über den Widerstand mit dem anderen Knoten (B) zu verbinden und gleichzeitig den Anschluß mit dem Register (16) für logische Zustände zu verbinden, um in diesem Register einen zweiten logischen Pegel zu speichern, der demjenigen entspricht, auf dem der Anschluß in der zweiten Phase gehalten wird;
- wobei die Schaltung außerdem einen Dekodierer (18) aufweist, um ein vom Register (16) zur Speicherung von logischen Zuständen ausgehendes Signal zu liefern, welches den Zustand des Anschlusses anhand einer Kombination der logischen Pegel, die der Anschluß im Verlauf der beiden Phasen angenommen hat, definiert.

2. Schaltung gemäß Anspruch 1, dadurch gekennzeichnet, daß das Register die beiden logischen Pegel speichert, die der Anschluß im Verlauf der beiden Phasen des Lesens jeweils angenommen hat, wobei das Register zwei entsprechende Ausgänge hat, die an die Eingänge des Dekodierers angelegt sind.

3. Schaltung gemäß einem der Ansprüche 1 und 2, dadurch gekennzeichnet, daß zwischen den Anschluß und das Register eine Pufferstufe (14) geschaltet ist und daß ein Schalter (S4) vorgesehen ist, um die Verbindung zwischen dem Anschluß und dem Eingang der Pufferstufe außerhalb der beiden Phasen des Lesens zu unterbrechen und um dann diesen Eingang auf einem hohen oder niedrigen logischen Pegel zu halten.

4. Schaltung gemäß einem der Ansprüche 1 bis 3, dadurch gekennzeichnet, daß die Schalter umfassen:
- einen ersten und einen zweiten Schalter (S1 und S2), die zwischen zwei Versorgungsanschlüssen der integrierten Schaltung in Reihe geschaltet sind, wobei der Widerstand zwischen den Anschluß und den mittleren Punkt der beiden Schalter geschaltet ist,
- einen dritten Schalter (S3), um den Anschluß mit dem Register zu verbinden, und einen vierten Schalter (S4), um das Register mit einem Versorgungsanschluß zu verbinden.

## Claims

1. An integrated circuit comprising an input pin (10) on which one state is to be detected among three states corresponding to two logic levels and a high impedance state, a resistor (12) connected to the pin, a set of interruptors (S1 - S4) connected between the pin, the resistor and two circuit nodes (A and B) at potentials which represent a first and a second logic level respectively, a memory register (16) for memorising at least two logic states, and a control means for controlling the interruptors, whereby:
- in a first reading phase, to connect the pin to one of the nodes (A) through the resistor, and simultaneously to connect the pin to the logic state register (16) so as to memorise in the said register a first logic level corresponding to the level to which the pin is brought during the said first phase;
- in a second reading phase, to connect the pin to the other node (B) through the resistor, and simultaneously to connect the pin to the logic state register (16) for the memorisation, in the said register, of a second logic state corresponding to the state to which the pin is brought in the said second phase;
the circuit further including a decoder (18) for providing a signal derived from the logic state memory register (16), with the said signal defining the state of the pin derived from a combination of the logic levels assumed by the pin in the course of the two phases.

2. A circuit according to Claim 1, characterised in that the register memorises the two logic levels assumed by the pin during the two respective reading phases, the register having two corresponding outputs applied to the inputs of the decoder.

3. A circuit according to Claim 1 or Claim 2, characterised in that a buffer stage (14) is interposed between the pin and the register, and in that an interruptor (S4) is provided for the purpose of disconnecting the pin from the input of the buffer stage outside the two reading phases, and for accordingly maintaining the said input at a high or low logic level.

4. A circuit according to one of Claims 1 to 3, characterised in that the interruptors comprise:
- a first interruptor and a second interruptor (S1 and S2) in series between two supply terminals of the integrated circuit, the resistor being connected between the pin and the mid-point of the two interruptors,
- a third interruptor (S3) for connecting the pin to the register, and a fourth interruptor (S4) for connecting the register to a supply terminal.
